Europäisches Patentamt

European Patent Office

Office européen des brevets

(11) Veröffentlichungsnummer: **0 590 434 A1**

# (12) EUROPÄISCHE PATENTANMELDUNG

(21) Anmeldenummer: **93114966.0**

(22) Anmeldetag: **16.09.93**

(51) Int. Cl.5: **H01F 10/16**, C22C 9/06, C22C 45/00, H01L 43/10, C22F 1/08

(30) Priorität: **29.09.92 DE 4232682**
**07.04.93 DE 4311516**

(43) Veröffentlichungstag der Anmeldung:
**06.04.94 Patentblatt 94/14**

(84) Benannte Vertragsstaaten:
**AT DE ES FR GB IT NL**

(71) Anmelder: **SIEMENS AKTIENGESELLSCHAFT**
**Wittelsbacherplatz 2**
**D-80333 München(DE)**

(72) Erfinder: **Wecker, Joachim, Dr. Dipl.-Phys.**
**Georg-Krauss-Strasse 2**
**D-91056 Erlangen(DE)**
Erfinder: **von Helmolt, Rittmar, Dipl.-Phys.**
**Donaustrasse 14**
**D-91052 Erlangen(DE)**

(54) **Verfahren zur Herstellung eines Aufbaus mit erhöhtem Magnetowiderstand und Verwendung des Aufbaus.**

(57) Mit dem Verfahren ist ein Aufbau mit einem erhöhten Magnetowiderstand auf Basis des Stoffsystems Cu-Co insbesondere für einen magnetoresistiven Sensor herzustellen. Erfindungsgemäß wird zunächst ein Zwischenprodukt des Aufbaus aus einer Legierung mit an Co übersättigten Cu-Mischkristallen mittels einer Rascherstarrungstechnik ausgebildet und wird anschließend dieses Zwischenprodukt mittels einer vorbestimmten Wärmebehandlung in ein Endprodukt des gewünschten Aufbaus mit Ausscheidungen aus oder mit Co in einer Cu-Matrix überführt.

FIG 2

EP 0 590 434 A1

Die Erfindung bezieht sich auf ein Verfahren zur Herstellung eines Aufbaus mit erhöhtem Magnetowiderstand auf Basis des Stoffsystems Cu-Co. Ein derartiges Verfahren geht aus "Appl. Phys. Lett.", Vol. 58, No. 23, 10.6.1991, Seiten 2710 bis 2712 hervor. Die Erfindung betrifft ferner die Verwendung eines solchen Aufbaus.

Der allgemeine Aufbau und die Funktionsweise von magnetoresistiven Sensoren mit Dünnfilmen aus ferromagnetischen Übergangsmetallen sind z.B. in der Veröffentlichung "Sensors", Vol. 5, 1989, Seiten 341 bis 380 näher erläutert. Die dort offenbarten, weitgehend magnetostriktionsfreien Schichten, die z.B. aus einer speziellen NiFe-Legierung ("Permalloy") oder aus einer speziellen NiCo-Legierung bestehen, zeigen jedoch nur einen verhältnismäßig geringen magnetoresistiven Effekt $M_r$ von etwa 2 bis 3 %. Die Größe $M_r$ ist dabei im allgemeinen folgendermaßen definiert: $M_r = [R(O) - R(B)]/ R(O)$, wobei R(B) der ohmsche Widerstand des Aufbaus in einem äußeren Magnetfeld mit der Induktion B und R(O) der entsprechende Widerstand bei fehlendem Magnetfeld sind.

Man ist an einer Erhöhung dieses magnetoresistiven Effektes interessiert, um so Sensoren mit verbessertem Signal-Rausch-Verhältnis realisieren und den Einsatzbereich dieser Sensoren erweitern zu können. Eine Erhöhung des magnetoresistiven Effektes konnte bei einigen Mehrschichtsystemen wie Co/Cu, Co/Cr und Fe/Cr nachgewiesen werden (vgl. z.B. "Phys. Rev. Lett.", Vol. 64, No. 19, 7.5.1990, Seiten 2304 bis 2307). Hierbei wird von der Tatsache ausgegangen, daß die nicht-magnetische Zwischenschicht eine Austauschkopplung (Austausch-Wechselwirkung) bewirkt, die von der Dicke der Zwischenschicht abhängt (vgl. Beitrag B.C.O7 der "35th Annual Conference on Magnetism and Magnetic Materials" (MMM-Konferenz), San Diego, USA, 29.10. bis 1.11.1990). Diese Austauschkopplung ist für das magnetische Verhalten (ferromagnetisch-antiferromagnetisch) des Mehrschichtensystems verantwortlich.

Demnach können Mehrschichtsysteme mit unterschiedlicher Richtung der Polarisation der übereinanderliegenden ferromagnetischen, durch nicht-magnetische Schichten getrennten Einzelschichten einen erhöhten magnetoresistiven Effekt hervorrufen. Dieser Effekt, der für geschichtete Cu-Co-Dünnfilmstrukturen bei Raumtemperatur bis zu $M_r = 40 \%$ betragen kann (vgl. die eingangs genannte Literaturstelle aus "Appl. Phys. Lett." 58), wird deshalb auch als "Giant Magnetoresistive Effect" bezeichnet ("Phys. Rev. Lett.", Vol. 61, No. 21, 21.11.1988, Seiten 2472 bis 2475).

Die Beschränkung auf Multilagensysteme und die starke Abhängigkeit des Effektes von der sehr geringen Dicke der magnetischen bzw. nicht-magnetischen Schichten im Nanometer-Bereich stellt jedoch hohe Anforderungen an die Prozeßtechnik und schränkt den Einsatzbereich auf Dünnschichtstrukturen ein. Außerdem sind geeignete Substrate als Träger für das Multilagensystem erforderlich.

Darüber hinaus sind Versuche bekannt, nach denen ein magnetoresistiver Effekt auch in granularen Systemen auftreten kann (vgl. "Phys. Rev. Lett.", Vol. 68, No. 25, 1992, Seiten 3745 bis 3752). Bei diesem bekannten Verfahren werden CuCo-Legierungsschichten durch simultanes Zerstäuben der Elemente hergestellt und durch eine anschließende Wärmebehandlung nanokristalline (magnetische) Co-Ausscheidungen in einer (nicht-magnetischen) Cu-Matrix erzeugt. Der in diesen Dünnfilmen zu messende magnetoresistive Effekt $M_r$ beträgt jedoch nur höchstens 7 % bei Raumtemperatur.

Aufgabe der vorliegenden Erfindung ist es, das Verfahren mit den eingangs genannten Merkmalen dahingehend auszugestalten, daß mit ihm auf verhältnismäßig einfache Weise ein insbesondere schicht- oder bandförmiger Aufbau mit einem erhöhten magnetoresistiven Effekt von insbesondere über 8 % zu erhalten ist, wobei eine gute Reproduzierbarkeit dieser Eigenschaft gewährleistet ist.

Diese Aufgabe wird erfindungsgemäß mit den im Kennzeichen des Anspruchs 1 angegebenen Maßnahmen gelöst. Der damit zu erhaltende Aufbau schließt hierbei auch eine einlagige Ausführungsform mit einer einzigen Schicht mit ein.

Das erfindungsgemäße Verfahren beruht somit im wesentlichen auf der Herstellung eines übersättigten Cu-Mischkristalls als erstem Schritt, aus dem heraus durch die vorbestimmte Wärmebehandlung eine feine Verteilung von Co-Ausscheidungen oder Co-haltigen Ausscheidungen in einer Cu-Matrix gebildet werden. Die Gleichgewichtslöslichkeit von Co in Cu beträgt maximal 5,6 Atom-% bei 1110 °C. Eine höhere Übersättigung, wie sie bei dem erfindungsgemäßen Verfahren möglich ist, wird bisher nur mit Verfahren erreicht, die auf niedrige Prozeßtemperaturen beschränkt bleiben wie z.B. mit dem mechanischen Legieren oder dem Sputtern bzw. Verdampfen, d.h. der Kondensation aus der Gasphase. Der Grund hierfür ist, daß Cu und Co ein System mit positiver Mischungswärme bilden, d.h. die Tendenz zeigen, schon in der Schmelze zu entmischen.

Dem erfindungsgemäßen Verfahren liegt nun die Erkenntnis zugrunde, daß trotz dieser mit der positiven Mischungswärme des Stoffsystems Cu-Co verbundenen Probleme über die Rascherstarrung aus der Schmelze eine Co-Übersättigung eingestellt werden kann, die die Voraussetzung für einen verhältnismäßig hohen Magnetowiderstand des Endproduktes darstellt. Die mit dem erfindungsgemäßen Verfahren verbundenen Vorteile sind nun insbesondere darin zu sehen, daß auf verhältnismäßig einfache Weise über die Rascherstarrungstechnik vorzugsweise bandförmige Endprodukte zu erhalten sind, die selbsttragend und duktil sind und insbesondere für Sensoranwendungen zu Spulen oder zu anderen Gestaltungsformen leicht aufgewickelt werden können.

Das erfindungsgemäße Verfahren ist nicht nur auf das binäre Stoffsystem Cu-Co beschränkt. Vielmehr kann vorteilhaft zur Ausbildung des Zwischenproduktes dem Cu-Co-Stoffsystem eine Komponente X aus mindestens einem Element in einer solchen Menge zugesetzt werden, daß der X-Anteil in dem Stoffsystem Cu-Co-X höchstens 10 Atom-% beträgt. Dabei ist das mindestens eine Element der Komponente X aus der Gruppe der 3d-Elemente (Elemente mit 3d-Elektronenkonfiguration) wie Eisen (Fe), Nickel (Ni) usw. mit einer Ordnungszahl zwischen 21 und 30 (einschließlich) bzw. aus der 3. Hauptgruppe des Periodensystems wie Bor (B), Aluminium (Al), Gallium (Ga), Indium (In), Tallium (Tl) auszuwählen. Die Wärmebehandlung ist so durchzuführen, daß in der Cu-Matrix die Co-Ausscheidungen wenigstens zu einem Teil als mindestens eine Verbindung Co-X gebunden sind. So wird beispielsweise mit einem Zusatz Fe oder B zu dem binären Cu-Co-Stoffsystem die Herstellung, insbesondere eine Formgebung, des Zwischenproduktes gegenüber dem binären System erleichtert, ohne daß eine wesentliche Beeinträchtigung des Magnetowiderstandseffektes zu beobachten ist. Die optimale Wärmebehandlung zur Erzeugung der Co-Ausscheidungen ist hier im allgemeinen bei einer gegenüber dem binären System etwas verminderten Temperatur durchzuführen. Eine Bildung von intermetallischen Verbindungen des Fe oder B mit Cu tritt dabei nicht auf.

Vorteilhafte Ausgestaltungen des erfindungsgemäßen Verfahrens gehen aus den entsprechenden abhängigen Ansprüchen hervor.

Die Erfindung wird nachfolgend anhand von Ausführungsbeispielen noch weiter erläutert, wobei auch auf die Zeichnung Bezug genommen wird. Dabei zeigen deren Figuren 1 und 2 jeweils in einem Diagramm für das Stoffsystem Cu-Co die Widerstandsänderung als Funktion der Auslagerungszeit bzw. den elektrischen Widerstand als Funktion des Magnetfeldes. Das Diagramm der Figur 3 gibt für dieses Stoffsystem den Einfluß der Auslagerungstemperatur wieder. In den Figuren 4 und 5 ist jeweils in einem Diagramm für das Stoffsystem Cu-Co-B bzw. Cu-Co-Fe der elektrische Widerstand als Funktion des Magnetfeldes dargestellt.

Mit dem erfindungsgemäßen Verfahren ist ein dünner, im allgemeinen langgestreckter Körper wie z.B. ein schicht- oder bandförmiges Bauteil herzustellen, das vorzugsweise selbsttragend sein kann und deshalb besonders für Sensoranwendungen geeignet ist. Das Bauteil soll gemäß einem ersten Ausführungsbeispiel aus dem binären Stoffsystem Cu-Co ausgewählt sein. Sein Aufbau wird somit erfindungsgemäß aus einer $Cu_{1-x}Co_x$-Legierung hergestellt, die mit Co übersättigte Cu-Mischkristalle aufweist. Hierzu muß für den Index x gelten: 0,01 < x < 0,7, vorzugsweise 0,02 ≤ x ≤ 0,6, insbesondere 0,05 ≤ x ≤ 0,25. Generell sollen die Grenzen für die Anteile der beiden Komponenten bis zu ± 5 Atom-% von den angegebenen Werten abweichende Werte mit einschließen. Darüber hinaus kann die angegebene Zusammensetzung noch minimale Verunreinigungen mit jeweils unter 0,2 Atom-% pro Verunreinigungselement enthalten.

Eine entsprechende CuCo-Legierung wird gemäß einem ersten Verfahrensschritt des erfindungsgemäßen Verfahrens unter Anwendung einer Rascherstarrungstechnik hergestellt. Hierzu werden zunächst die Ausgangskomponenten des Materials mit hinreichender Reinheit unter einer gereinigten Ar-Atmosphäre zu einer Vorlegierung erschmolzen, wobei z.B. von einer kompaktierten Pulvermischung der Komponenten ausgegangen wird. Die Anteile der einzelnen Komponenten werden dabei so gewählt, daß die Vorlegierung zumindest annähernd die Zusammensetzung des gewünschten Materials aufweist. Zum Erschmelzen können insbesondere pyrolythische BN- oder $Al_2O_3$-Tiegel verwendet werden. Auch ein Erschmelzen in einem Lichtbogenofen ist möglich. Die so erhaltene Vorlegierung aus den Ausgangskomponenten wird dann mittels einer an sich bekannten Rascherstarrungstechnik in ein feinkristallines Zwischenprodukt überführt. Als Rascherstarrungstechniken kommen beispielsweise spezielle Sputter- oder Spraytechniken zur Ausbildung dünner Schichten auf hierfür geeigneten Substraten oder eine Herstellung von Metallpulvern durch spezielle Verdüsungs- oder Atomisierungstechniken in Frage. Besonders geeignet ist das sogenannte "melt spinning" (Schmelzspinnverfahren), ein Rascherstarrungsverfahren, das zur Herstellung insbesondere amorpher Metalllegierungen allgemein bekannt ist (vgl. z.B. "Zeitschrift für Metallkunde", Band 69, Heft 4, 1978, Seiten 212 bis 220 oder "Physikalische Blätter", 34. Jg., 1978, Seiten 573 bis 584). Demgemäß wird unter Schutzgas wie z.B. Ar oder unter Vakuum die Vorlegierung z.B. in einem Quarz-oder BN-Tiegel mit Hochfrequenz auf eine Temperatur zwischen 1300 ° und 1600 °C, insbesondere zwischen 1450 °C und 1550 °C erschmolzen. Die Schmelze wird dann durch eine Düse mit einem Düsendurchmesser von beispielsweise 0,5 mm und einem Preßdruck von z.B. 0,25 bar zur Abschreckung auf den beispielsweise 5 cm breiten Rand eines hierfür geeigneten, rotierenden Körpers, vorzugsweise eines Kupferrades gespritzt. Das Rad sollte dabei mit einer solchen Drehzahl rotieren, daß man die geforderten übersättigten Cu-Mischkristalle erhält, d.h. in einem gegenüber dem thermodynamischen Gleichgewicht erweiterten Bereich der Löslichkeit von Co in Cu arbeitet. Diese metastabile Löslichkeitserweiterung erkennt man z.B. in einer charakteristischen Verschiebung der Bragg-Reflexe von Cu in Röntgenbeugungsexperimenten. Um diese Löslichkeitserweiterung zu erreichen, müssen verhältnismäßig hohe Oberflächengeschwindigkeiten $v_s$ auf dem Radumfang gewährleistet werden. Im allgemeinen sind Geschwindigkeiten $v_s$ zwischen 10 m/s und 80 m/s, insbesondere zwischen 40 m/s und 60 m/s erforderlich. Man erhält dann bandförmige Stücke des Zwischenproduktes, die verhältnismäßig duktil sind. Dabei ist der Grad der Übersättigung insbesondere von der Radgeschwindigkeit, dem Preßdruck und der Temperatur der Schmelze abhängig.

Zur Einstellung der gewünschten Ausscheidungsmorphologie ist erfindungsgemäß noch eine nachfolgende Wärmebehandlung des Zwischenproduktes erforderlich. Hierzu können vorteilhaft Temperaturen $T_a$ zwischen 100 und 1000 °C, für das ausgewählte binäre Stoffsystem vorzugsweise zwischen 300 und 600 °C vorgesehen werden. Die Zeiten $t_a$ für diese Wärmebehandlung, die sogenannten Auslagerungszeiten, sind mit der Temperatur $T_a$ korreliert und liegen im allgemeinen zwischen 1 Minute und 4 bis 10 Stunden, für das ausgewählte binäre Stoffsystem vorzugsweise zwischen 20 und 120 Minuten.

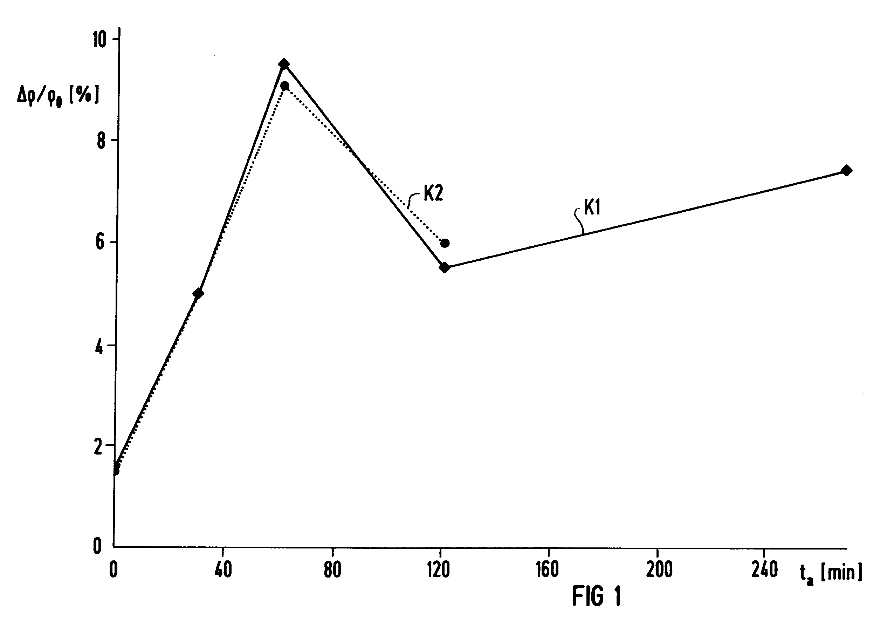

Das Diagramm der Figur 1 zeigt die Widerstandsänderung anhand der relativen Änderung $\Delta\rho/\rho_o$ (in %) des spezifischen Widerstands für zwei verschiedene rascherstarrte CuCo-Bänder als Funktion der Auslagerungszeit $t_a$ (in Minuten). Hierbei ist $\rho_o$ der spezifische Widerstand ohne ein äußeres Magnetfeld, während für $\Delta\rho$ gilt:
$\Delta\rho = (\rho(B) - \rho_o):\rho_o$. $\rho(B)$ ist der spezifische Widerstand in einem Magnetfeld mit der Induktion B. Die durchgezogene Kurve K1 ergibt sich für eine $Cu_{90}Co_{10}$-Legierung, während für eine $Cu_{80}Co_{20}$-Legierung die punktierte Kurve K2 erhalten wird. Diese Legierungen wurden jeweils bei 1500 °C aufgeschmolzen, auf einem rotierenden Cu-Rad mit einer Oberflächengeschwindigkeit $v_s$ von 60 m/s abgeschreckt und während verschiedener Zeiten $t_a$ bei einer Temperatur $T_a$ von 500 °C ausgelagert. Wie aus dem Diagramm hervorgeht, ergibt sich der größte Effekt nach einer Auslagerungszeit $t_a$ von etwa 60 Minuten, wobei eine weitgehende Unabhängigkeit von der Zusammensetzung der Legierung festzustellen ist.

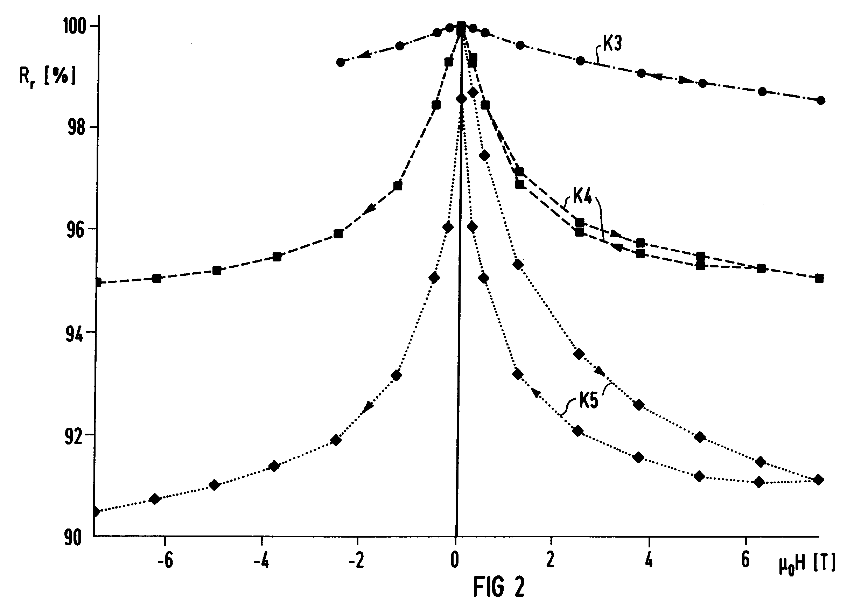

Der Einfluß der Auslagerungszeit $t_a$ läßt sich auch aus dem Diagramm der Figur 2 ablesen. In diesem Diagramm ist der relative elektrische Widerstand $R_r$ (in %) in Abhängigkeit von einem äußeren Magnetfeld der Flußdichte $\mu_o * H$ (in T) für verschiedene rascherstarrte und wärmebehandelte $Cu_{90}Co_{10}$-Legierungen wiedergegeben. Der relative elektrische Widerstand $R_r$ ist dabei definiert als der Quotient aus dem bei einem äußeren Magnetfeld der Feldstärke H oder der Induktion B gemessenen ohmschen Widerstand R(H) bzw. R(B) zu dem sich bei fehlendem Feld ergebenden Widerstand R(O). Die sogenannten Legierungen waren ebenfalls bei 1500 °C aufgeschmolzen und auf ein rotierendes Cu-Rad mit $v_s$ = 60 m/s aufgespritzt. Der Verlauf der strichpunktiert eingezeichneten, mit K3 bezeichneten Kurven ergibt sich, wenn von der erfindungsgemäßen thermischen Nachbehandlung zur Auslagerung des Co im rascherstarrten Material abgesehen wird. Hier ist somit das Zwischenprodukt zugrundegelegt. Die gestrichelten Kurven K4 werden nach einer 30minütigen Auslagerung dieses Materials bei $T_a$ = 500 °C erhalten. Eine 60minütige Auslagerung bei dieser Temperatur $T_a$ führt zu einem Verlauf der punktiert veranschaulichten Kurven K5. Die an den einzelnen Meßkurven eingezeichneten Pfeile geben dabei den Richtungssinn der jeweiligen Messung bei etwa 300 K (nach größeren oder kleineren Feldstärken hin) wieder. Aus einer Zusammenschau aller Kurven läßt sich erkennen, daß im abgeschreckten Zustand ohne Auslagerungsbehandlung nur eine Widerstandsänderung von etwa 1 % erhalten wird, während sich die Widerstandsänderung mittels der 60minütigen Auslagerung auf über 9 % erhöht. Die Auslagerungsbehandlung führt also erst zu den gewünschten hohen Werten des Magnetowiderstands.

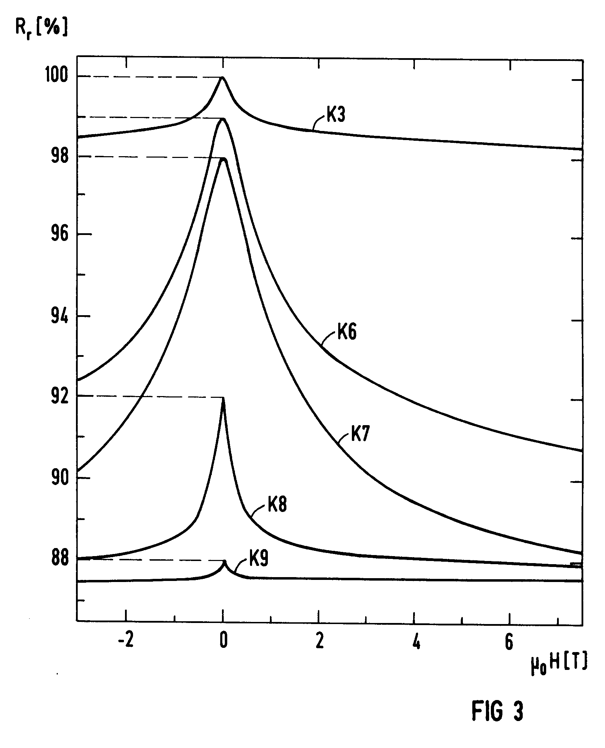

Das Diagramm der Figur 3 gibt in Figur 2 entsprechender Darstellung den Einfluß der Auslagerungstemperaturen $T_a$ für eine auch hier zugrunde gelegte $Cu_{90}Co_{10}$-Legierungwieder. Diese Legierung wurde entsprechend den Ausführungen zu Figur 2 hergestellt. Das thermisch nicht nachbehandelte Material führt zu einem wiederum mit K3 bezeichneten Kurvenverlauf. Die mit K6, K7, K8, K9 bezeichneten Kurven ergeben sich für eine Auslagerungstemperatur $T_a$ von 400 °C (Kurve K6) bzw. von 450 °C (Kurve K7) bzw. von 500 °C (Kurve K8) bzw. 600 °C (Kurve K9). Aus den verschiedenen Kurvenverläufen ist ersichtlich, daß Auslagerungstemperaturen $T_a$ zwischen etwa 400 °C und 500 °C zu besonders hohen Effekten führen.

Bei den vorstehenden, den Figuren 1 bis 3 zugrundegelegten Ausführungsbeispielen wurden Legierungen aus dem binären Stoffsystem Cu-Co angenommen. Das Verfahren nach der Erfindung und die Verwendung eines mit diesem Verfahren hergestellten Aufbaus in einem magnetoresistiven Sensor sind jedoch nicht auf ein Stoffsystem mit nur zumindest im wesentlichen zwei Komponenten beschränkt. Es wurde nämlich erkannt, daß dem binären Stoffsystem Cu-Co in geringem Maße noch einzelne weitere Elemente hinzulegiert werden können, ohne daß die magnetoresistiven Eigenschaften, insbesondere der magnetoresistive Effekt $M_r$, sich deutlich verschlechtern. Gegebenenfalls kann damit sogar eine noch weitere Erhöhung des magnetoresistiven Effektes verbunden sein. Konkrete weitere Elemente sind insbesondere das Eisen (Fe) und das Bor (B). Ein mit einem dieser Elemente herzustellendes Bauteil soll demnach einen Aufbau aus einer CuCoFe- oder CuCoB-Legierung der exakten oder ungefähren Zusammensetzung $Cu_x Co_y X_z$ aufweisen, die mit Co übersättigte Cu-Mischkristalle aufweist. Hierzu muß für den Index y (jeweils in Atom-%) gelten: $1 < y < 70$, vorzugsweise $2 \leq y \leq 60$, insbesondere $5 \leq y \leq 20$. Für den Anteil z (jeweils in Atom-%) des zu dem binären Stoffsystem Cu-Co als Komponente X zugesetzten Fe oder B soll gelten: $0 < z \leq 10$, vorzugsweise $1 \leq z \leq 5$. Unter einer Co-Übersättigung wird dabei verstanden, die verhältnismäßig große Löslichkeit im thermodynamischen Gleichgewicht bei hohen Temperaturen durch eine besondere Führung des Herstellungsverfahrens bei tiefen Temperaturen (Raumtemperatur) quasi einzufrieren. Die maximale Löslichkeit von Co in Cu beträgt nämlich bei ca. 1110 °C etwa 5,6 Atom-%. Demgegenüber liegt im thermodynamischen Gleichgewicht die Löslichkeit bei verhältnismäßig tiefen Temperaturen deutlich niedriger (unter 1 % für Temperaturen unter 400 °C). Darüber hinaus kann die angegebene Zusammensetzung noch minimale Verunreinigungen mit jeweils unter 0,2 Atom-% pro Verunreinigungselement enthalten. Der Rest der Legierung zu 100 Atom-% besteht zumindest im wesentlichen aus dem als eine Matrix dienenden Cu.

Als ein konkretes Ausführungsbeispiel sei nachfolgend auf ein Verfahren zur Herstellung einer entsprechenden CuCoB-Legierung, beispielsweise der Zusammensetzung $Cu_{80} Co_{17} B_3$, näher eingegangen. Das Herstellungsverfahren basiert auf dem vorstehend zu dem binären Stoffsystem Cu-Co erläuterten Verfahren. Dementsprechend wird aus einer Vorlegierung aus den nunmehr mindestens drei Ausgangskomponenten mittels einer an sich bekannten Rascherstarrungstechnik wie z.B. mittels des Schmelzspinnverfahrens ein feinkristallines Zwischenprodukt erzeugt. Hierzu wird die Vorlegierung auf einer Temperatur zwischen 1300° und 1600 °C erschmolzen und anschließend auf einen rotierenden Körper gespritzt, der eine verhältnismäßig hohe Oberflächengeschwindigkeit $v_s$ an seinem Radumfang aufweist. Die Geschwindigkeit $v_s$ liegt dabei zwischen 10 m/s und 80 m/s. Man erhält so bandförmige Stücke des Zwischenproduktes, die verhältnismäßig duktil sind.

In einem zweiten Schritt wird dann in dem Zwischenprodukt die gewünschte Ausscheidungsmorphologie mittels einer Wärmebehandlung eingestellt. Die hierfür erforderliche Temperatur $T_a$

sowie die Auslagerungszeit $t_a$ sind dabei so zu wählen, daß sich einerseits die geforderten Ausscheidungen auf Co-Basis ergeben, wobei das Co ganz oder nur zu einem Teil an das B in Form von Boriden, z.B. als CoB und/oder $Co_2 B$ und/oder $Co_3 B$, gebunden wird. Insbesondere werden die Stöchiometrie des Zwischenproduktes und die Wärmebehandlung so eingestellt, daß nicht alles Co, vorzugsweise weniger als 50 % des Co, als Borid gebunden wird. Vorteilhaft können hierfür Temperaturen $T_a$ zwischen 100 und 700 °C, vorzugsweise zwischen 200 und 500 °C vorgesehen werden. Die Zeiten $t_a$ für diese Wärmebehandlung bzw. Auslagerung sind mit der Temperatur $T_a$ korreliert und liegen im allgemeinen zwischen 5 Minuten und 4 Stunden, vorzugsweise zwischen 45 Minuten und 90 Minuten. Hierbei ist eine weitgehend Unabhängigkeit der Auslagerungszeiten von der jeweiligen Zusammensetzung der gewählten Legierung festzustellen.

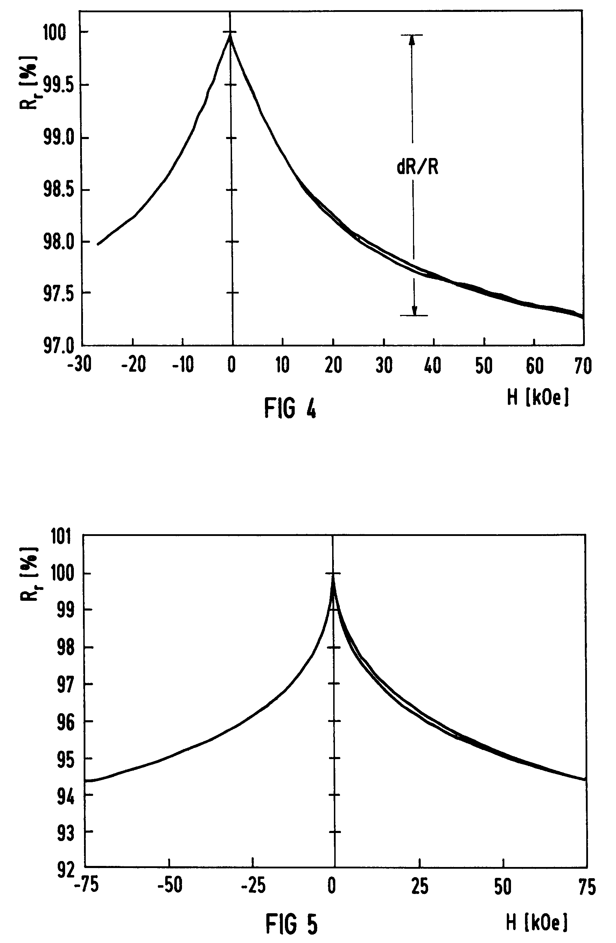

Die in dem Diagramm der Figur 4 wiedergegebene Kurve zeigt die Magnetfeldabhängigkeit des relativen elektrischen Widerstandes eines erfindungsgemäß nach den vorstehend beschriebenen Verfahrensschritten hergestellten 3-komponentigen Legierungsbandes. In dem Diagramm sind in Abszissenrichtung das angelegte (äußere) Magnetfeld der Stärke H (in kOe, wobei $1 Oe = 10^3/4\pi$ A/m) und in Ordinatenrichtung der davon abhängige relative elektrische Widerstand $R_r$ aufgetragen. Dem Ausführungsbeispiel ist eine rascherstarrte und wärmebehandelte $Cu_{90} Co_9 B_1$-Legierung zugrundegelegt. Hierzu wurde eine entsprechende Pulvermischung dieser Legierung bei 1500 °C aufgeschmolzen und auf ein rotierendes Cu-Rad mit $v_s = 60$ m/s aufgespritzt. Der gezeigte Kurvenverlauf ergibt sich nach einer 60minütigen Auslagerung des so hergestellten Legierungsbandes bei einer Temperatur $T_a = 500$ °C. Aus dem Kurvenverlauf ist eine maximale relative Widerstandsdifferenz $dR/R = (R(O)-R(H))/R(O)$ von etwa 2,6 % abzulesen, welche der Größe des magnetoresistiven Effektes $M_r$ des erfindungsgemäß hergestellten Aufbaus entspricht.

Verzichtet man zu Vergleichszwecken auf die Auslagerungsbehandlung eines entsprechend zusammengesetzten Legierungsbandes, so beträgt die maximale relative Widerstandsdifferenz nur etwa 1 %.

Legt man als weitere Ausführungsbeispiele mit einer B-Komponente Magnetowiderstandslegierungen der ternären Zusammensetzung $Cu_{97} Co_2 B_1$ oder $Cu_{39} Co_{60} B_1$ oder $Cu_{93} Co_2 B_5$ oder $Cu_{35} Co_{60} B_5$ zugrunde, so werden ähnliche Verhältnisse wie für die vorstehend beschriebene $Cu_{90} Co_9 B_1$-Legierung beobachtet.

Bei den vor stehend konkret beschriebenen 3-komponentigen Ausführungsbeispielen wurde als ternäre Komponente X des Stoffsystems Cu-Co-X das Element B angenommen. Stattdessen kann als Komponente X auch das Element Fe gewählt werden, um einen erfindungsgemäßen Aufbau mit einem erhöhten magnetoresistiven Effekt $M_r$ in der Größenordnung des Stoffsystems Cu-Co-B zu erhalten. Die Anteile der einzelnen Komponenten in dem Stoffsystem Cu-Co-Fe entsprechen dabei denen des Systems Cu-Co-B. Beispiele für entsprechende Legierungen sind das $Cu_{97}Co_2Fe_1$, $Cu_{39}Co_{60}Fe_1$, $Cu_{93}Co_2Fe_5$ oder $Cu_{35}Co_{60}Fe_5$.

Figur 5 zeigt in einem Diagramm eine sich für eine $Cu_{90}Co_8Fe_2$-Legierung ergebende Meßkurve. Für das Diagramm ist eine Figur 3 entsprechende Darstellung gewählt. Die $Cu_{90}Co_8Fe_2$-Legierung wurde entsprechend der Figur 4 zugrundegelegten Legierung mit B-Komponente gemäß der Erfindung hergestellt. Die maximale relative Widerstandsdifferenz bzw. der magnetoresistive Effekt $M_r$ beträgt hier etwa 5,5 %.

Selbstverständlich ist es auch möglich, für den erfindungsgemäß herzustellenden Aufbau mit erhöhtem Magnetowiderstand eine Komponente X vorzusehen, die neben dem Element Fe zu einem vergleichsweise geringeren Anteil, vorzugsweise unter 35 Atom-% in der Komponente X, das Element B enthält. Ein entsprechendes Beispiel wäre das $Cu_{70}Co_{20}Fe_8B_2$.

**Patentansprüche**

1. Verfahren zur Herstellung eines Aufbaus mit erhöhtem Magnetowiderstand auf Basis des Stoffsystems Cu-Co, **dadurch gekennzeichnet,** daß zunächst ein Zwischenprodukt des Aufbaus aus einer Legierung mit an Co übersättigten Cu-Mischkristallen mittels einer Rascherstarrungstechnik ausgebildet wird und daß anschließend dieses Zwischenprodukt mittels einer vorbestimmten Wärmebehandlung in ein Endprodukt des gewünschten Aufbaus mit Ausscheidungen aus oder mit Co in einer Cu-Matrix überführt wird.

2. Verfahren nach Anspruch 1, **dadurch gekennzeichnet,** daß als Rascherstarrungstechnik ein Schmelzspinnverfahren vorgesehen wird.

3. Verfahren nach Anspruch 2, **dadurch gekennzeichnet,** daß für das Schmelzspinnverfahren die Legierungskomponenten bei einer Temperatur zwischen 1300 °C und 1700 °C, insbesondere zwischen 1450 °C und 1550 °C, aufgeschmolzen werden.

4. Verfahren nach Anspruch 2 oder 3, **dadurch gekennzeichnet,** daß für das Schmelzspinnverfahren die erschmolzenen Legierungskomponenten zur Rascherstarrung auf einen rotierenden Körper aufgespritzt werden, dessen Umfangsgeschwindigkeit $v_s$ mindestens 10 m/s, vorzugsweise mindestens 40 m/s, und höchstens 80 m/s, vorzugsweise höchstens 60 m/s, beträgt.

5. Verfahren nach einem der Ansprüche 1 bis 4, **dadurch gekennzeichnet,** daß die Wärmebehandlung des Zwischenproduktes bei einer Auslagerungstemperatur $T_a$ zwischen 100 °C und 1000 °C, vorzugsweise zwischen 200 °C und 600 °C, durchgeführt wird.

6. Verfahren nach einem der Ansprüche 1 bis 5, **dadurch gekennzeichnet,** daß die Wärmebehandlung des Zwischenproduktes während einer Auslagerungszeit $t_a$ zwischen 1 Minuten und 4 Stunden, vorzugsweise zwischen 10 Minuten und 90 Minuten, durchgeführt wird.

7. Verfahren nach einem der Ansprüche 1 bis 6, **dadurch gekennzeichnet,** daß eine Zusammensetzung einer $Cu_{1-x}Co_x$-Legierung vorgesehen wird, für die zumindest gilt:
$0,01 < x < 0,7$,
insbesondere $0,05 \leq x \leq 0,25$.

8. Verfahren nach einem der Ansprüche 1 bis 6, **dadurch gekennzeichnet,**
- daß zur Ausbildung des Zwischenprodukts dem Cu-Co-Stoffsystem eine Komponente X in einer solchen Menge Zugesetzt wird, daß der X-Anteil in dem Stoffsystem Cu-Co-X höchstens 10 Atom-% beträgt, wobei das mindestens eine Element der Komponente X aus der Gruppe der Elemente mit 3d-Elektronenkonfiguration oder der 3. Hauptgruppe ausgewählt ist,

und
- daß die Wärmebehandlung so durchgeführt wird, daß in der Cu-Matrix die Co-Ausscheidungen wenigstens zu einem Teil als mindestens eine Verbindung Co-X gebunden sind.

9. Verfahren nach Anspruch 8, **dadurch gekennzeichnet,** daß mit der Wärmebehandlung weniger als 50 % des Co in der Verbindung Co-X gebunden werden.

10. Verfahren nach Anspruch 8 oder 9, **dadurch gekennzeichnet,** daß eine Zusammensetzung der $Cu_xCo_yX_z$-Legierung vorgesehen wird, für deren Anteile y und z (jeweils in Atom-%) gilt:
$1 < y < 70$, vorzugsweise $2 \leq y \leq 60$, und $0 < z \leq 10$, vorzugsweise $1 \leq z \leq 5$.

**11.** Verwendung des nach dem Verfahren gemäß einem der vorangehenden Ansprüche hergestellten Aufbaus für einen magnetoresistiven Sensor.

FIG 1

EP 0 590 434 A1

FIG 2

FIG 3

FIG 4

FIG 5

Europäisches Patentamt

**EUROPÄISCHER RECHERCHENBERICHT**

| | EINSCHLÄGIGE DOKUMENTE | | EP 93114966.0 |
|---|---|---|---|

| Kategorie | Kennzeichnung des Dokuments mit Angabe, soweit erforderlich, der maßgeblichen Teile | Betrifft Anspruch | KLASSIFIKATION DER ANMELDUNG (Int Cl.⁵) |
|---|---|---|---|
| A | CHEMICAL ABSTRACTS, Band 106, Nr. 6, 9. Februar 1987, Columbus, Ohio, USA INAGAKI, M. et al. "Magneto-resistance in crystalline and amorphous iron-cobalt-nickel based alloys" Seiten 622,623 Zusammenfassung-Nr. 40 043d & Jpn. J. Appl. Phys., Part 1 1986, 25(10), 1514-17 -- | 1 | H 01 F 10/16 C 22 C 9/06 C 22 C 45/00 H 01 L 43/10 C 22 F 1/08 |
| A | CHEMICAL ABSTRACTS, Band 108, Nr. 16, 18. April 1988, Columbus, Ohio, USA CHEN, H. et al. "Magneto-resistance and magnetic breakdown phenomenon in amorphous magnetic alloys." Seite 686, Zusammenfassung--Nr. 141 776t & Wuli Xuebao, 1987, 36(10), 1281-8 -- | 1 | |
| A | CHEMICAL ABSTRACTS, Band 116, Nr. 16, 20. April 1992, Columbus, Ohio, USA SHEPELEVICH, V.G. "Structure and electric properies of rapidly quenched antimony--selenium alloy foils." Seiten 297,298 Zusammenfassung-Nr. 156 641j & Vesti Akad. Navuk BSSR, Ser. Fiz.-Tekh. Navuk 1991, (3), 15-17 -- | 1 | **RECHERCHIERTE SACHGEBIETE (Int Cl.⁵)** H 01 F C 22 C C 22 F H 01 L G 11 B |
| A | EP - A - 0 498 668 (IBM) * Zusammenfassung * ---- | 11 | |

Der vorliegende Recherchenbericht wurde für alle Patentansprüche erstellt.

| Recherchenort | Abschlußdatum der Recherche | Prüfer |
|---|---|---|
| WIEN | 14-12-1993 | LUX |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, überein-stimmendes Dokument